Europäisches Patentamt

European Patent Office

Office européen des brevets

(11) Publication number: **0 267 416**
**A2**

# EUROPEAN PATENT APPLICATION

(21) Application number: 87114430.9

(22) Date of filing: 02.10.87

(51) Int. Cl.⁴ **H01L 21/00** , **B65G 54/02** , **H02K 41/02**

(30) Priority: 13.11.86 US 930202

(43) Date of publication of application:
**18.05.88 Bulletin 88/20**

(84) Designated Contracting States:
**DE FR GB IT**

(71) Applicant: International Business Machines Corporation
Old Orchard Road
Armonk, N.Y. 10504(US)

(72) Inventor: Feldsine, Timothy Robert
206 Carpenter Hill Road
Stanfordville, N.Y. 12581(US)
Inventor: Freisitzer, Norbert
Browning Road
Hyde Park New York 12538(US)
Inventor: Meinert, Rolf Gerd
5 Gold Road
Wappingers Falls New York 12590(US)

(74) Representative: Bonin, Jean-Jacques
Compagnie IBM France Département de Propriété Intellectuelle
F-06610 La Gaude(FR)

(54) Contactless transport device.

(57) A transport device for use in clean room applications which is designed so that no stationary and moving parts come in contact. The device comprises a support member with a surface; a translating member with at least one surface thereof disposed adjacent to the support member surface for translating relative to the support member surface; with an air bearing formed between the support member surface and the translating member surface. The device further comprises a brushless magnetically coupled D.C. motor with the armature thereof connected to the translating member so that the armature is supported relative to its stator by the air bearing between the support member and the translating member. The translation of the translating member may have three degrees of freedom. The invention may be used to form a linear transport system, or to obtain circular or spherical translation similar to that obtained from a cylinder joint or ball joint.

FIG.1

## CONTACTLESS TRANSPORT DEVICE

Background of the Invention

The present invention relates generally to transport and/or positioning systems, and more particularly to transport and positioning systems for use in clean rooms.

There are a variety of manufacturing applications where transport and/or positioning of an item must take place in an atmosphere maintained essentially particle-free in order to prevent the contamination of the items being manufactured. The most notable of these applications is in the area of semiconductor chip manufacturing. Semiconductor chip manufacturing is typically accomplished in what is commonly referred to as a "clean room", wherein floating particulate matter, dust, etc., is kept to an absolute minimum. As the electronic devices resulting from this manufacturing process became smaller and smaller in dimension, the degree to which the clean room is particle-free becomes critical. In this regard, even single dust particles present during the manufacturing process can now contaminate and cause an electronic chip to fail.

Many clean rooms currently utilize a flow of filtered air from the ceiling of the room down through gratings in the clean room floor to remove dust particles, etc. However, air turbulence is a continuing problem with this method of removing particulate matter from the clean room atmosphere.

The present invention is directed to removing a source which generates a substantial amount of the particulate matter in the clean room atmosphere. In this regard, it is well known that contact between moving and stationary members of the transport and positioning equipment in the clean room generates a substantial amount of particulate matter. Typical linear actuators require guiding mechanical ways with rollers or balls, as well as a mechanism, such as a lead screw or an air cylinder, for permitting the motor to move the assembly along the guiding ways. This type of structure thus includes a substantial amount of particle-generating rolling or sliding friction. Likewise, typical robot ball joints and cylindrical joints have a substantial amount of particle-generating friction.

Attempts have been made to remove the particles generated by this machinery by positioning the parts subject to friction down-wind in a specially-designed air flow directed away from the areas holding the chips. However, such air-flow type solutions are expensive, limit the usable work area, and generally are ineffective. Moreover, there are a variety of closed tool chambers which utilize transport and/or positioning machinery within their chambers. The air flow in the clean room has no effect on particulate matter generated within such closed tool chambers.

The claimed invention is intended to remedy the above-described problems caused by particulate matter generated by rolling and sliding friction in transport and positioning systems located in a clean room and/or within wafer processing tool chambers.

The advantage offered by the present invention is that all friction-contact between stationary and moving parts in transport and positioning systems is eliminated. Accordingly, the transport and/or positioning systems of the present invention may be used in Class 10 or better clean rooms, and within the wafer processing tools themselves. Additionally, particle-flight-path and down-wind positioning constraints on equipment positioning within the clean room are no longer a problem.

Summary of the Invention

Briefly, the present invention is a transport device, comprising

a support member with a surface;

a translating member with at least one surface thereof disposed adjacent to the support member surface for translating relative to the support member surface;

means for forming an air bearing between the support member surface and the at least one translating member surface;

a brushless magnetically coupled motor including a stationary stator and an armature which moves relative to the stator when the motor is operating; and

means for causing the air bearing to physically support the armature so that the stator and the armature are in adjacency but do not make physical contact.

In one embodiment of the present invention, the support causing means comprises a frame member for connecting the armature to the translating member so that the translating member moves with the armature.

In a preferred embodiment of the present invention, the magnetically coupled motor is a brushless D.C. linear motor. In this motor, the armature is disposed within a portion of the stator.

In one embodiment of the present invention, the support member includes a rail, and the translating member includes a platform, with the at least one surface of the translating member operable to

3　　　　　　　**0 267 416**　　　　　　　4

translate along a length of the rail. In a preferred embodiment, this translating means may comprise a slide which wraps substantially around the rail, with the air bearing being formed between the rail the inner surfaces of the slide.

In a further embodiment of the present invention, the support member surface may include a portion of a sphere. In this embodiment, the stator may take the shape of a portion of the outer shell of a first sphere; the armature may take the shape of at least a portion of a sphere disposed concentrically within the outer shell of the stator; and the support causing means may comprise a connecting member for connecting the armature sphere to the platform member.

In yet a further embodiment of the present invention, the support member may comprise a housing; and the translating member may comprise a cylinder joint disposed within the housing, with the air bearing formed between the cylinder joint and the housing. In this embodiment, the stator may be in the shape of at least a portion of a hollow second cylinder; and the armature may be in the shape of a third cylinder disposed concentrically within the stator hollow cylinder.

In a further embodiment of the present invention, the motor armature may comprise a cylindrical rotor, with the motor stator comprising a housing for enclosing the rotor. In this embodiment, the stator acts as the support member, the rotor acts as the translating member, and the support causing means comprises means for forming an air bearing between the cylindrical rotor and its stator.

Brief Description of the Drawings

Fig. 1 is a schematic diagram of one embodiment of a linear transport system in accordance with the present invention.

Fig. 2 is a schematic sectioned side view (diagrammatic only) illustrating the basic concept of the linear transport system of Fig. 1.

Fig. 3 is a schematic diagram of one embodiment of a cylindrical joint made in accordance with the present invention.

Fig. 4 is a schematic diagram of a second embodiment of a cylindrical joint made in accordance with the present invention.

Detailed Description of the Preferred Embodiment

The present invention is a transport and/or positioning assembly which accomplishes its function without contact between stationary and moving members of the assembly. This design is based on the unique concept of utilizing a brushless magnetically coupled motor in conjunction with an air bearing guide, wherein the air bearing also has the function of physically supporting the armature for the magnetically coupled motor so that there is no physical contact between the armature and the stator of the motor.

The present invention has applicability to a wide variety of manufacturing applications where transport and/or positioning of an item must take place in an atmosphere maintained essentially particle-free. The particular form in which the present invention may be embodied will depend on the particular application which is being performed.

In order to illustrate the present invention, it will be described in the context of three specific examples. The first example demonstrates the application of this invention to a linear or curvilinear transport system. The second and third embodiments of the present invention illustrate its application for cylindrical and ball joints, of the type that might be utilized to implement a robot.

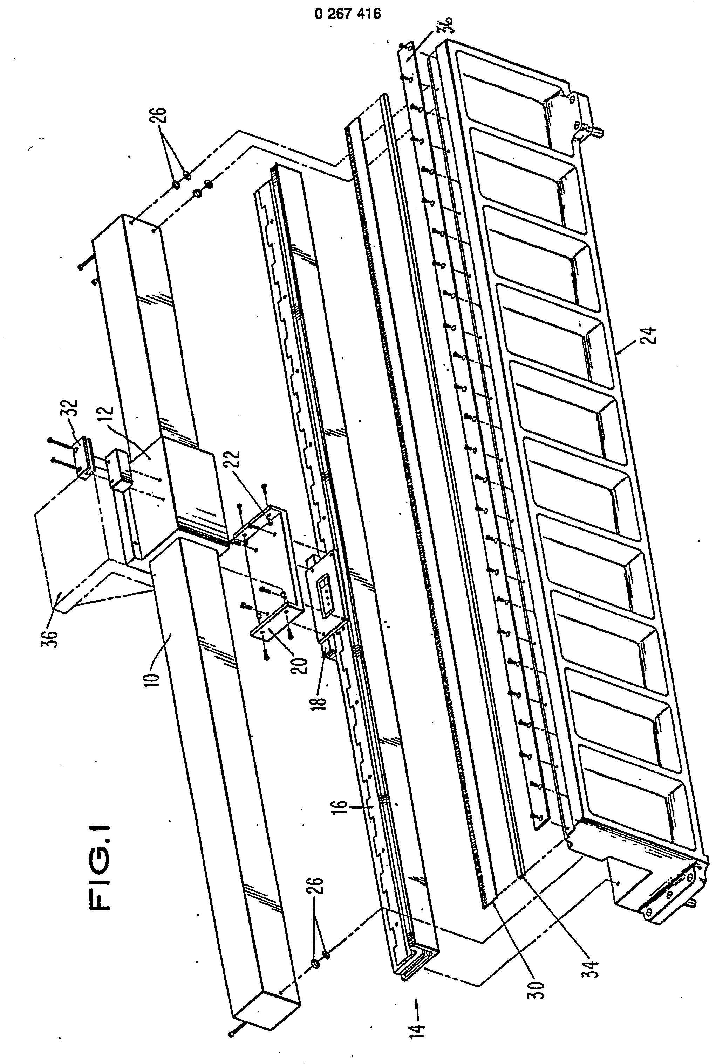

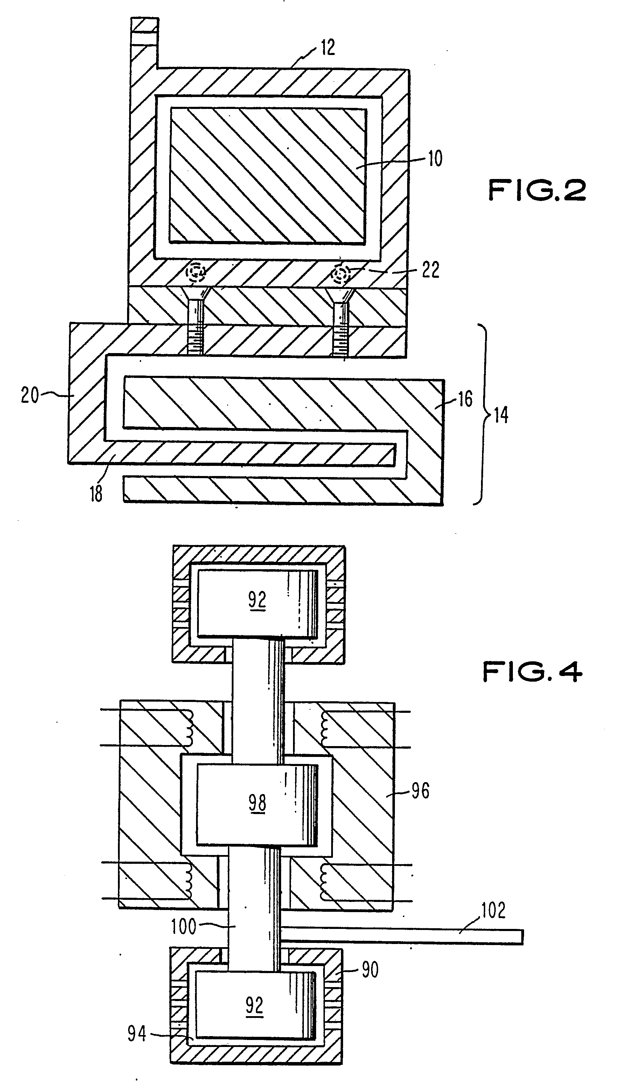

Referring now to the Figures, Fig. 1 shows one embodiment for performing a totally contactless linear or curvilinear transport function. Fig. 2 is a sectioned side-view of the basic concept of Fig. 1. Note that Fig. 2 is not to scale, and is provided for illustrative purposes only.

With reference to Figs. 1 and 2, there is shown a support member 10 with a surface; a translating member 12 with at least one surface thereof disposed adjacent to the support member 10 for translating relative to the support member surface; means for forming an air bearing between the support member surface and the at least one translating member surface; a brushless magnetically coupled motor 14 including a stationary stator 16 and an armature 18 which moves relative to the stator 16 when the motor 14 is operating; and means 20 for causing the air bearing to physically support the armature 18 so that the stator 16 and the armature 18 are in adjacency, but do not make physical contact. In a preferred configuration of this linear transport embodiment, the support member 10 may comprise a rail, and the translating means 12 may comprise a slide which wraps substantially around the rail 10. The air bearing is then formed between the rail 10 and the inner surfaces of the slide 12. By way of example, this rail-slide configuration with the air bearing may be implemented by part number 600S manufactured by Dover Instruments Corporation, Westboro, Massachusetts. This part utilizes compressed air or nitrogen to form the air bearing. The compressed air or nitrogen is uniformly distributed to the interface between the slide 12 and the slide rail 10 on all four sides thereof by means of a network of passages in the slide assembly. A very small and precise air gap between the slide 12 and the slide rail 10 holds the

3

air pressure which thus produces a film of air that supports the slide 12 on the slide rail 10. This film of air or air bearing allows the slide 12 to move along the slide rail 10 completely supported on this air bearing with no physical contact with the slide rail 10.

In a preferred embodiment, the magnetically coupled motor may be a brushless D.C. linear motor, with the armature thereof disposed within a portion of the stator. By way of example, one such motor that may be utilized is part number L-1-B-46 manufactured by Anorad Corporation, Hauppauge, New York. This brushless motor has no rolling or sliding parts which are subject to possible bounce, arc, or wear. This motor is a direct-drive, linear, D.C. servo-actuator which provides smooth, straight-line motion. It utilizes a three-phase, full-wave, motor control system. This motor comes in two configurations, a moving coil configuration and a moving magnet configuration. The moving coil configuration has the electromagnetic coils in the moving member, and the permanent magnets in the fixed base. This configuration comprises a long, U-shaped magnetic assembly which houses a series of rare earth magnets. The magnetic assembly is the stationary component of the design, and is configured with the upper and lower level magnets identically spaced, but opposite in polarity. This is the configuration shown in Figs. 1 and 2, wherein the upper and lower parts of the stator 16 comprise the U-shaped magnet assembly. The upper level magnets in this stator provide a magnetic flux field for improved force generating capacity during operation. The coil assembly in this Anorad device comprises a series of overlapped and insulated copper coils, which are precision wound and pinched for a 120° conduction cycle. This coil assembly is housed in an aluminum housing and comprises the armature 18 of the present invention. A set of three Hall-effect sensors are mounted on the coil assembly frame for the purpose of commutating the coils of the armature 18. These Hall-effect sensors are positioned to respond to the established pitch of the coils and the magnets. Note that this moving coil configuration of the Anorad motor requires that motor power and commutator cabling be attached to the moving armature member 18. This means that provision must be made to accommodate cables that are equal in length to the nominal travel of the motor armature 18.

The Anorad motor is also designed to have a moving magnet configuration comprising precision wound coil/lamination sets formed in the stator 16, and a moving short magnet assembly as the armature 18. As the magnet structure of the armature 18 moves, only those coils in the stator 16 which are under the magnet are actuated by the non-contact Hall-effect sensors to control the coil set. The above described brushless D.C. linear motor provides smooth ripple-free translation, and high speed motion when required.

In accordance with the present invention, the armature 18 of the motor 14 is coupled to the air bearing slide 12 by means of an interface bracket 20 and rubber shock/misalignment bushings 22. The bushings 22 provide resilience between the linear motor armature 18 and the air bearing slide 12 to compensate for any minor misalignment and to provide mechanical damping between these two components.

The above described components are disposed on a mechanical base casting 24 by means of a three-point mounting system. The three-point mounting system mounts the slide rail 10 by means of 3 spherical alignment washers 26, as shown in the Figure, to thereby prevent torsional distortion of the slide rail 10, when mounted.

The preferred embodiment may further comprise a position indicator disposed in adjacency to a path on the support member surface over which the translating member 12 translates; and a position reader disposed on the translating member 12 for reading the position indicator and controlling the operation of the motor 14 in accordance with this reading. In the embodiment shown in Fig. 1, an encoder grating 30 is utilized to provide position feedback for a servo system connected to the slide 12. An encoder reader 32 is disposed on the slide 12 for reading this encoder grating 30. It can be seen that there is no physical contact between the encoder reader 32 and the encoder grating 30. By way of example, the encoder reader and attendant electronics may be implemented by encoder part number EE9-50 manufactured by Anorad Corporation.

The above described encoder grating 30 and encoder reader 32 operate as follows. The encoder reader has a grating thereon with a similar pitch and in the same direction as the grating formed in the encoder grating 30. It is known that the relative position of two gratings of similar pitch causes the formation of Moire fringe patterns. By mounting the short index grating disposed on the encoder reader 32 to move in front of and relative to the long stationary grating 30, a series of Moire fringes is produced. These fringes are detected by the encoder reader 32 which then generates sinusoidal electrical signals for determining the position of the slide 12. In the embodiment shown in Fig. 1, the encoder grating 30 is disposed on top of a rubber mounted on encoder glass member 34, and is held in place by a clamp plate 36.

A variety of different load-bearing mechanisms may be attached to the slide 12. In Fig. 1, a platform 36 is shown attached to the slide 12. This platform 36 may simply be a wafer chuck.

It should be noted that the linear brushless D.C. motor shown in Fig. 1 could be replaced by a linear stepper motor operating in an open loop configuration. Such a motor does not have precision velocity and position capabilities, however.

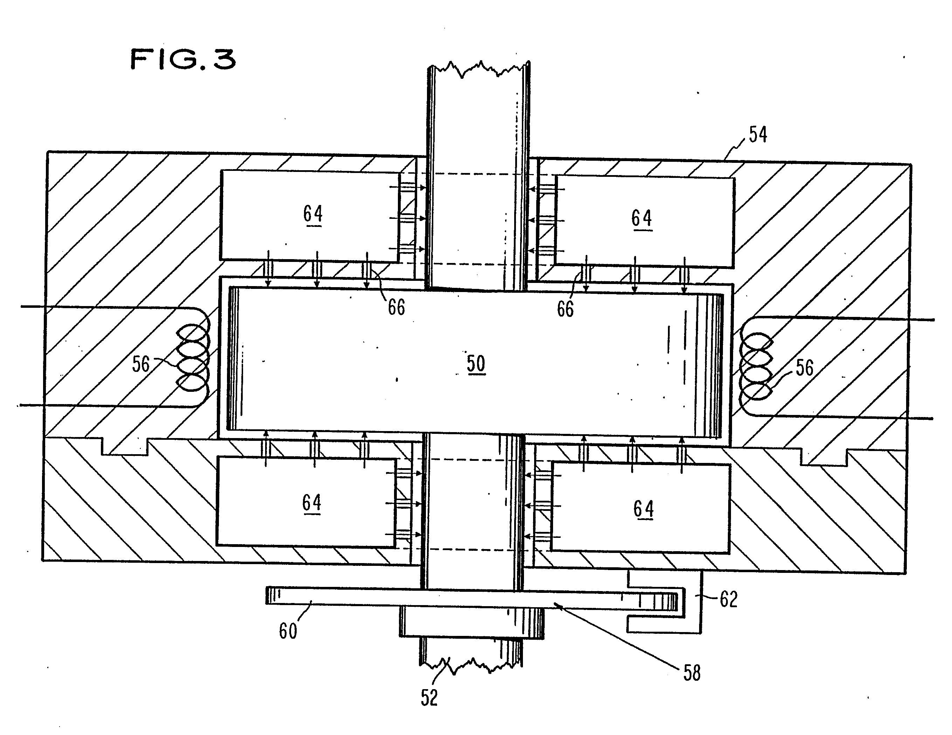

Referring now to Fig. 3, there is shown a second embodiment of the present invention. The purpose of the configuration shown in Fig. 3 is to obtain rotational motion for a given assembly. In the embodiment of Fig. 3, a cylindrical rotor 50 is disposed on a shaft 52. A stator housing 54 encloses the rotor 50. In the example of Fig. 3, the rotor 50 includes a set of permanent magnets disposed on its periphery in the well known manner. Likewise, the stator 54 includes a set of stator windings 56 (two such windings are shown in the Figure) to form a magnetically-coupled D.C. motor configuration. The stator windings 56 are commutated by an electronic commutator 58, comprising a disc 60 disposed on the shaft 52, and a standard optical sensor device 62 for sensing rotational position on the disc 60.

Means are also provided to form an air bearing between the stator 54 and the rotor 50. In the embodiment of Fig. 3, this means comprises a set of air plenums 64 disposed within the stator 54 above and below the rotor cylinder 50. These air plenums 64 communicate with the space between the rotor 50 and the stator 54 by means of a set of openings 66 through the section of the stator separating the air plenums from this space. The air emanating from these holes 66 forms an air bearing which supports the rotor 50 within the stator 54.

Standard means may be utilized to harness this rotary motion to perform work. By way of example, a platform could be disposed for rotation at the end of the shaft 52. Likewise, a shaft member could be connected to some point on the shaft 52 to rotate therewith and perform a desired function.

It should be noted that in this embodiment of the invention, the stator comprises the support member for the device, and the rotor comprises the translating member.

In a different embodiment shown in Fig. 4 (not drawn to scale), the support member comprises a housing 90, and the translating member for translating relative to the support member 90 comprises a cylinder joint 92 disposed within the housing, with an air bearing formed in a space 94 between the cylinder joint 92 and the housing 90. In this embodiment, the motor comprises a stator 96 in the shape of at least a portion of a hollow second cylinder, with appropriate electrical windings disposed therein, and an armature 98 98 in the shape of a third cylinder with appropriate permanent magnets disposed therein, with the armature disposed concentrically within the stator hollow cylinder 96. In this embodiment, the support-causing means comprises a member 100 connecting from the axis of the armature cylinder 98 to the translating member cylinder joint 92.

It is clear from the Figure that the air bearing formed in the space 94 operates to support both the cylinder joint 92 and the armature 98, so that there is no frictional contact between moving and stationary parts in the assembly. Again, it is clear that there are a variety of methods for utilizing this rotational motion to operate on a load. By way of example, a member 102 may be connected either to the rotational joint 92 or to the connecting member 100. This member 02 may operate as a rotating platform, or may perform some other desirable function.

In a further embodiment, a ball-joint type motion is obtained which is supported by the air bearing of the present invention. In this embodiment, the support member surface may include a portion of the shell of a sphere. A translating member is disposed adjacent to this support member sphere for translating relative to this support member surface. An air bearing is formed in the space between the support member and the translating member. In the embodiment, the magnetically coupled motor includes a stator which is in the shape of a portion of the outer shell of a sphere, with a triaxial winding disposed therein. The motor further includes an armature in the shape of at least a portion of a sphere disposed concentrically within the outer shell of the stator. The armature includes appropriately disposed poles in order to effect the magnetically coupled motor configuration. The configuration further includes a connecting member as the support causing means for connecting the armature sphere 78 to the translating member 72. It can be seen that the air bearing operates to support both the translating member and the armature ball so that there is no frictional contact between moving and stationary members in the assembly. In addition to, or in the alternative, a second support member surface may be disposed above the translating member, and an air bearing formed in the space between the top surface of the translating member and this second support member. It should be noted that if the lower support member is utilized, then one or more slots must be formed therein in order for the support member to be able to rotate in various desired directions.

Again, there are a variety of methods for utilizing this rotational motion of the translating member to perform a desired function. For example, if the second support member is not present, then the top surface of the translating member may be utilized as a platform to perform some type of work.

Alternatively, this embodiment may be configured to form the air bearing between the armature sphere and the stator. Accordingly, the stator acts as the support member, and the outer spherical support members may be eliminated.

The above-described configuration is effective to provide rotational motion with two degrees of freedom. This configuration, as well as the configurations of Figs. 3 and 4, may be utilized to form joints in a variety of different assemblies, including robots.

The present invention comprises a design for a transport and/or positioning system with no contact between stationary and moving members of the assembly. This design eliminates all sources for particle generation associated with sliding or rolling mechanisms. The design has wide application, and is especially suitable for class 10 and better clean room applications for transporting and positioning a semiconductor wafer.

In prior art designs, air bearings have been used primarily to provide a smoother track for system movement, and to obviate problems with non-linear slide rails. The present invention utilizes an air bearing to provide a smooth track, but also uniquely interrelates the air bearing with a magnetically coupled drive motor so that the air bearing now supports the armature of this magnetically coupled motor. This unique configuration thus permits accurate and controllable motion without particulate generation.

It should be noted that the slide and the slide rail may be hard coated to prevent particulate erosion. Also, all air bearing slide orifices may be jeweled to prevent particulate erosion. The air supply utilized to form the air bearing may be either highly filtered air or nitrogen.

While the present invention has been particularly shown and described with reference to preferred embodiments therefor, it will be understood by those skilled in the art that the foregoing and other changes in form and detail may be made therein without departing from the spirit and the scope of the present invention, as defined in the appended claims.

## Claims

1. A transport and/or positioning device comprising:

a support member with a surface;

a translating member with at least one surface thereof disposed adjacent to said support member surface for translating relative to said support member surface;

means for forming an air bearing between said support member surface and said at least one translating member surface;

a brushless magnetically coupled motor including a stationary stator, and an armature which moves relative to said stator when said motor is operating; and

means for causing said air bearing to physically support said armature so that said stator and said armature are in adjacency, but do not make physical contact.

2. A transport device according to claim 1, characterized in that said support causing means comprises a frame member for connecting said armature to said translating member so that said translating member moves with said armature.

3. A transport device according to claim 1, characterized in that said magnetically coupled motor is a brushless D.C. linear motor.

4. A transport device according to claim 1, characterized in that said armature is disposed within a portion of said stator.

5. A transport device according to claim 1, characterized in that said support member includes a rail;

wherein said translating member includes a platform; and

wherein said at least one surface of said translating member is operable to translate along a length of said rail.

6. A transport device according to claim 5, characteried in that said rail has at least four sides; and

wherein said translating member includes at least four surfaces, disposed to remain in adjacency to said four rail sides as said translating member translates along said rail, and wherein said air bearing is formed between said at least four rail sides and said at least four translating member surfaces.

7. A transport device according to claim 1, characteried in that said support member includes a rail;

wherein said translating means comprises a slide which wraps substantially around said rail; and

wherein said air bearing is formed between said rail and inner surfaces of said slide.

8. A transport device according to claim 7, characterized in that said armature is suspended within a portion of said stator by said air bearing.

9. A transport device as defined in claim 1, further comprises a position indicator disposed in adjacency to a path on said support member surface over which said translating member may translate; and further comprising

a position reader disposed on said translating member for reading said position indicator and controlling the operation of said motor in accordance with said reading.

10. A transport device according to claim 1, characteried in that said motor armature comprises a cylindrical rotor; and

wherein said motor stator comprises a housing for enclosing said rotor.

11. A transport device according to claim 10, characteried in that said support member comprises said stator;

wherein said translating member comprises said rotor; and

wherein said supporting causing means comprises means for forming said air bearing between said rotor and said stator.

12. A transport device for use in clean atmosphere applications, comprising;

a rail; a slide wrapped around said rail for translating along said rail, said slide including a platform;

means for forming an air bearing between said rail and said slide to prevent any physical contact therebetween;

a brushless D.C. linear motor including an approximately linear stator, and an armature which is suspended adjacent thereto and which translates when said motor is operating; and

means for causing said air bearing to physically support said armature so that said armature does not physically contact said stator.

13. A transport device, according to claim 12 characteried in that said support causing means comprises a frame member for connecting said armature to said slide so that said slide with its platform moves with said armature.

FIG.1

FIG.2

FIG.4

FIG.3

0 267 416